# EUROPEAN PATENT APPLICATION

(11) **EP 0 936 847 A1**
(43) Date of publication of application: **18.08.1999**
(21) Application number: 98500253.4
(22) Date of filing: 24.11.1998
(51) Int. Cl.: H05K 1/02, H05K 1/14, B60R 16/02

(54) **Electronic integration in service boxes**

(30) Priority: 25.11.1997 ES 9702457
(71) Applicant: MECANISMOS AUXILIARES INDUSTRIALES S.A. M.A.I.S.A., E-43800 Valls, Tarragona (ES)
(72) Inventor: Arragones Carreta, Alberto, 43800 Valls (Tarragona) (ES)
(74) Representative: Morgades Manonelles, Juan Antonio

(57) **Abstract**

The improvements made on the main Invention Patent no. 9501610 consists, firstly, of manufacturing power circuits such as (23) of between 200 and 800 microns, see figure 4, whereby, and practically with the same voltage, the amperage or intensity which runs through the conducting tracks of the printed circuit broad (23) is doubled, it also being possible to fit relays (26) using the corresponding females (24), so that the services integrated on the box (10) can support a greater load, thereby expanding the possibilities of integration of services, with no type of modification made to configuration and structure.

## Description

This Patent of Invention application consists of "IMPROVEMENTS MADE TO INVENTION PATENT No. 9501610 by ELECTRONIC INTEGRATION IN SERVICE BOXES", whose new construction and design characteristics comply with the mission for which they have been specifically designed, with maximum safety and efficacy.

The Utility Model no. 291.764 of the same holder, whose object is a "UNIFIED MAIN TIME BOX FOR AUTOMOBILES", described and claimed a box divided into two semi-boxes, one of which contained all the electronics required for the operation and logical interpretation of all the signals received which, once they have been treated, execute the relevant signals for operating the electromechanical elements or solid-state semiconductors to carry out the relevant functions, all these elements being located in the other semi-box.

Patent no. 92.00325, of the same holder, explains the construction and architecture of a service box, as support for a number of interconnections of different power lines with their corresponding protections, incorporating, furthermore, other components, such as relays, electronic modules constructed using printed circuits combined by means of pins, conducting tracks and other electronic and electrical elements. Besides the foregoing, and to achieve greater integration through patent no. 9501610, the different electronic parts which regulate and control different functions, and which are distributed inside the automobile, were relocated to the inside of the aforementioned service box, thanks to the redesign of different architectures with the help of other new ones, so that signal circuits were combined with power circuits by means of totally novel interconnections.

For this purpose, printed circuits specially prepared to support a current strength of less than 5A were used, having a Cu conducting element with a thickness of 35 to 105 microns, and power circuits up to 400 microns thick, being able to support up to 400 A. This made it possible to construct architectures consisting of mixed power-signal circuits, involving additional advantages such as reduced weight and volume, reduction in manufacturing costs, ease of assembly of the box in the vehicle by the integration of several modules in one, with fewer connectors, less wiring, and fewer assembly errors, converting the service box into an electrical distribution and electronic function centre.

The term architecture used hitherto refers to geometric and other special configurations, such as the formal aspect, since the combination of printed circuits, be they power, signal or mixed ones, using elements such as jumpers, flexible circuit and staples, allows for an endless number of embodiments which, besides offering different possibilities and performances for the service box, may also adopt different external physical forms, albeit having the same inside volume, which will nevertheless have a different layout.

Thus, the importance of this double meaning conferred upon the concept of architecture provides for a whole range of different electronic functions, as well as external configurations which can be adapted to the different free volumes in the automobile in which the service box is to be installed.

The initial tests and applications of electronic integration in service boxes, described and claimed in Patent no. 9601610, as well as day-to-day practice, have brought to light a series of possible improvements, such as:
* Making the power printed circuits, and more specifically their conducting parts, thicker.
* Reducing thickness in the conducting parts of the signal circuits.
* Designing the mixed signal-power circuits on the same substrate, so that they may contain any combination of thicknesses according to the previous ranges.
* Modify the way the electronic circuits are assembled so that they can also be made with male-female connections.
* Design the mixed signal-power circuits so that they can also be multilayer.
* Change the types of interconnection between two conducting layers of a double-sided printed circuit with rigid substrate between 0.1 and 0.3 mm, so that this can also be effected through a soldered passing screw.
* Changing the types of interconnection between the conducting sides of a mixed printed circuit can be done by the metallisation of their screw holes.

All of these improvements would give rise to the same line and advantages sought in the previous registrations, such as the Utility Model No. 291.764 and the Invention Patents Nos. 9200325 and 9501610.

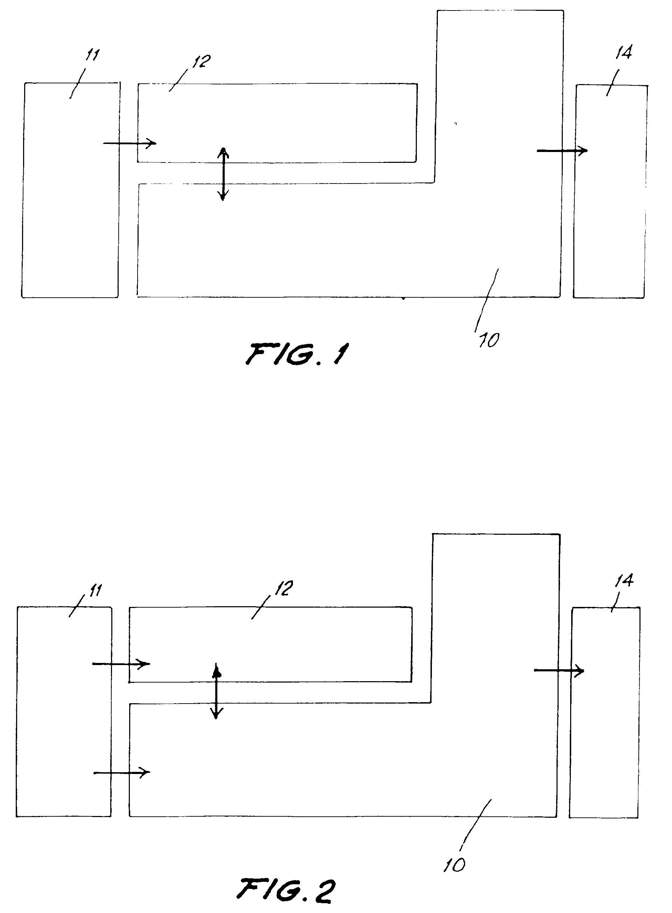

Other details and characteristics of this Patent application will become apparent in the course of the description provided hereunder, where reference is made to the figures attached to this abstract, the same ones as those used in the main patent no. 95.01610, i.e. figures nos. 1 to 14, which, somewhat schematically, represent the preferred details. These details are given by way of example, referring to a possible case of a practical embodiment, but are not limited to the details expounded herein; this description may therefore be regarded as an illustrative point of view, with no type of limitation whatsoever.

The following is a detailed list of the different elements mentioned in this Patent application, (10) service box, (11) set of switches, (12) electronic module, (13) pins, (14) set of loads, (15) 400-micron printed circuit, (16) dielectric support acting as substrate, (17) short pins, (18) electronic components, (19) different micron-size printed circuit, (20) 105-micron printed circuit, (21) long pins, (22) connectors, (23) power printed circuit, (24) females, (25) bent pins, (26) relays, (27) printed circuit, (28) staple.

Figure no. 1 is a schematic representation of a first level of integration, where part of the electronics of the electronic module (12) are integrated in the service box (10) in order to facilitate the number of interconnections, the connection being effected in the direction of the arrows shown in the figure.

Figure no. 2 is a schematic representation of a second level of integration, where part of the electronic functions of the electronic module (12) are integrated in the service box (10), so that the signals from the set of switches (11) act directly upon the service box (10), and the electronic module (12).

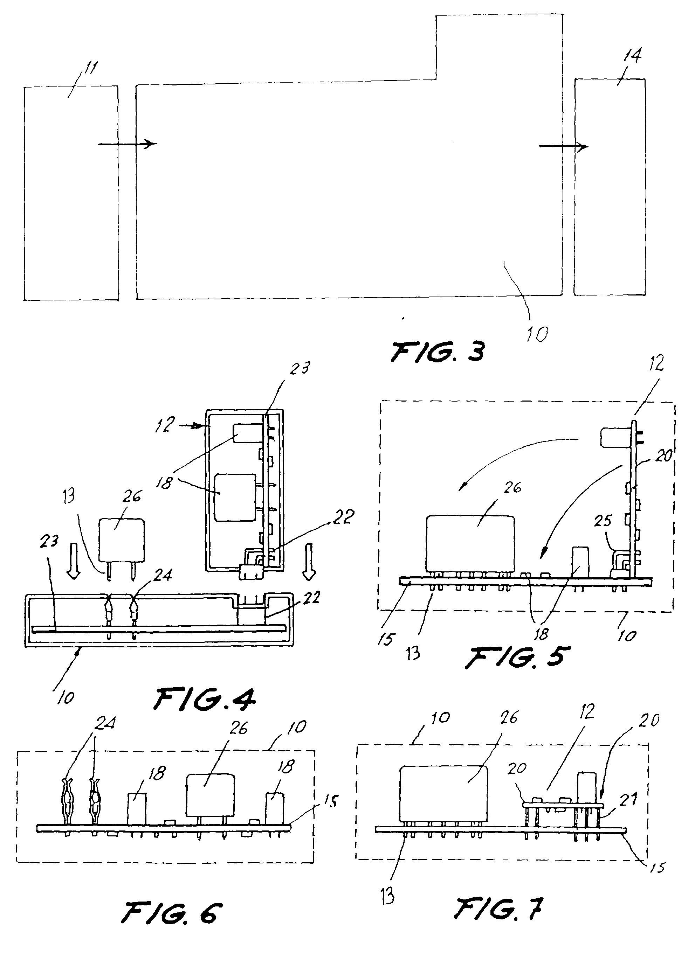

Figure no. 3 is a total integration diagram, in which the electronic module (12) disappears and is totally integrated within the service box (10).

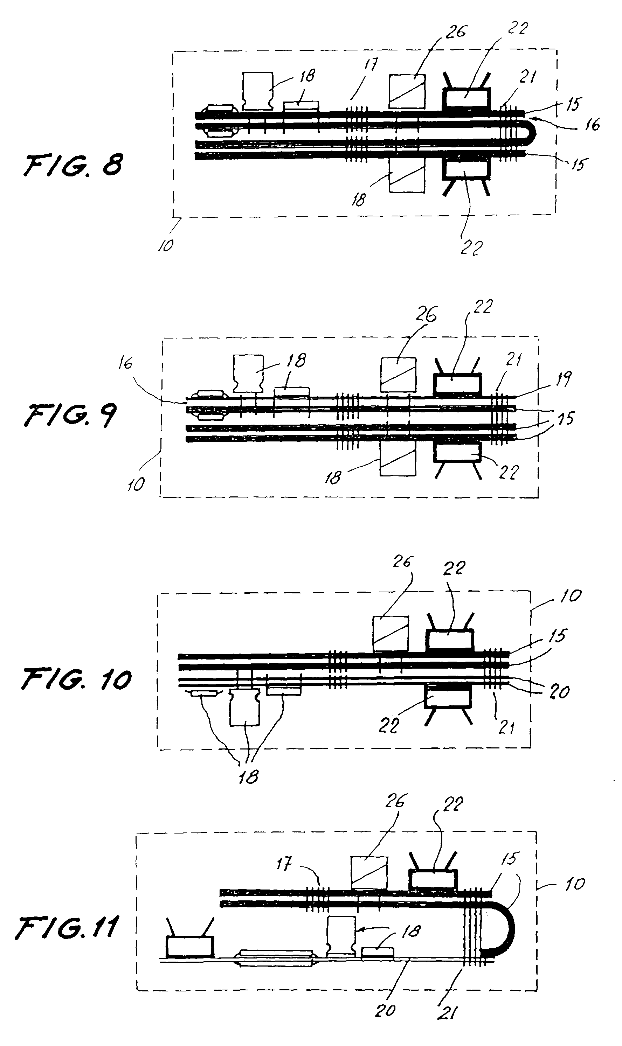

Figure no. 4 is a service box (10), according to the state of the art, where the electronic module (12) is connected, with the help of a connector (22), to a service box (10) inside which there is a power printed circuit (23) into which a number of females (24) have been inserted, and to which several conventional relays (26) are connected via their pins (13).

Figure no. 5 is an example of the application of the integration suggested in this Additional Patent application, showing how the electronic module (12), with the help of some bent pins (25), is soldered to a 400-micron printed circuit (15), as well as the electronic components (18), forming a single unit or service box (10), shown in dots schematically.

Figure no. 6 is a service box (10) constructed using a 105-micron mixed printed circuit (19), in which part of the electronic components (18) are soldered to the top side of the printed circuit (19), and part of them to the bottom side (19), as well as the females (24).

Figure no. 7 is one of the possible embodiments of this invention in which a service box (10) is formed by an electronic module (12) of 35 microns, integrated into a 400-micron printed circuit (15) with the help of the corresponding long pins (21).

Figure no. 8 shows, according to the present invention, an embodiment of a double-sided 400-micron printed circuit (15), bent at one end on the conducting part due to the removal of the dielectric support (16), in the folded area, where the electronic components (18 - 22 - 26) are soldered onto a 400-micron printed circuit.

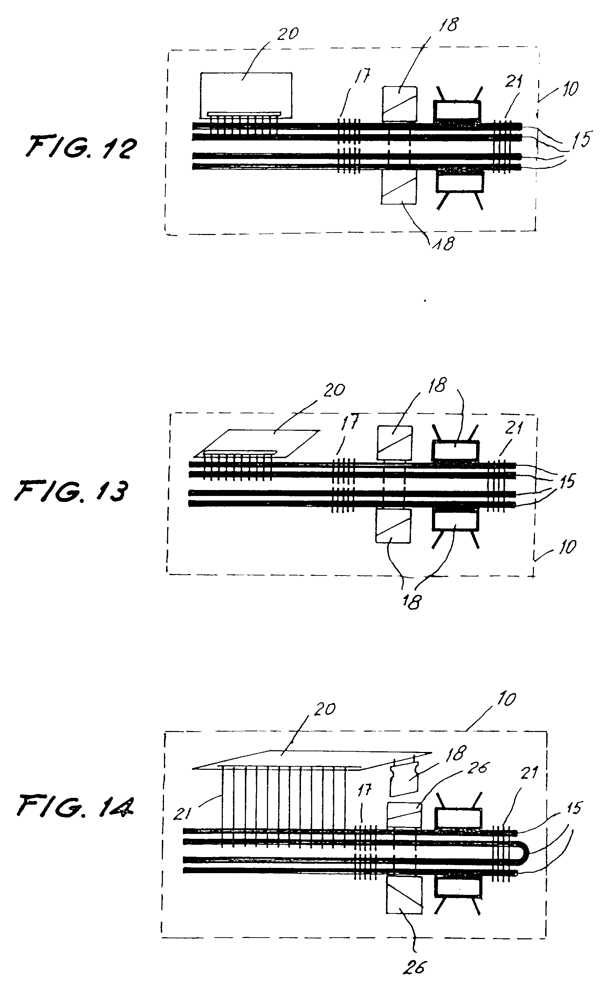

Figure no. 9 is another alternative embodiment according to the object of this invention, showing how a service box (10) can be constructed on the basis of a unit comprising some 400-micron printed circuit (15) boards and another mixed printed circuit (19) board with different Cu conductor micron sizes, where the electronic components (18) are soldered to the mixed circuit (19).

Figure no. 10 is another alternative embodiment according to this invention, where a service box (10) can be formed by a unit comprising one 400-micron printed circuit (15) board and another 105-micron double-sided printed circuit (20), where the electronic components (18) are soldered to the circuit (20), the signal is transmitted from the circuit (20) by stitching long pins (21) to the 400-micron power circuit (15) .

Figure no. 11 is another form of embodiment of the service box (10) constructed using one 400-micron printed circuit (15) stitched by short pins (17), with the bottom circuit (15) bent over and joined to an electronic circuit (20) stitched to both circuits (15) using long pins (21), incorporating the corresponding electronic components (18).

Figure no. 12 is another version of a service box (10) constructed using a set of two 400-micron power circuits (15) and another signal circuit (20) soldered to (15), with the 35-micron circuit (20) governing the power which flows through the 400-micron circuit (15).

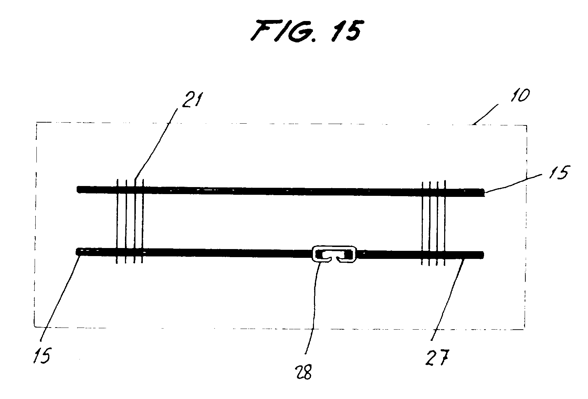

Figures nos. 13 and 14 represent different ways of positioning the 35- to 105-micron circuit (20) with vertical orientation, as shown in figure no. 12, or horizontally, as shown in figures nos. 13 and 14, using short pins (17) or long pins (21), with the corresponding electronic elements (18) positioned between (20) and (15).

Figure no. 15 is a schematic view of a combination of a 400-micron printed circuit (15) located at the top, combined, using long pins (21), with another two printed circuit boards (15-27) located under the former, with the staple (28) used to join the bottom ones.

One of the improvements made on the main Invention Patent no. 9501610 consists, firstly, of manufacturing power circuits such as (23) of between 200 and 800 microns, see figure 4, whereby, and practically with the same voltage, the amperage or intensity which runs through the conducting tracks of the printed circuit broad (23) is doubled, it also being possible to fit relays (26) using the corresponding females (24), so that the services integrated on the box (10) can support a greater load, thereby expanding the possibilities of integration of services, with no type of modification made to configuration and structure.

Another improvement in this invention, and inside the scope of the patent, and for new procedures which are not part of this application, is that it is now possible to manufacture signal printed circuits (20) with thicknesses in the conducting part of up to 200 microns, without there having to be fixed standards such as those defined in the main patent, of 35, 70 and 105 microns, and without this involving increased obtainment cost, which means that signal printed circuits with a conducting component thickness of up to 200 microns can be used in any of the embodiments described and represented in the figures.

As a consequence of the two aforementioned improvements, the mixed circuits, signal-power on the same substrate, another improvement will be attained, since such printed circuits may contain any combination of thicknesses according to the previous ranges, for example in the embodiment shown in figure no. 9, the electronic module (12) may be formed by a mixed printed circuit, with a printed circuit (15) of up to 800 microns being incorporated, connected by long pins (21) to (15), whereby the service box (10) will enjoy far superior characteristics in terms of amperage.

Another of the additional improvements proposed in this application consists of the use, besides short pins (17) or long pins (21), of male-female connections in the assembly of electronic circuits (20) in embodiments such as the one shown in Figure no. 13.

Alternatively, the mixed signal-power circuits may be multilayer, thereby facilitating shielding operations between both circuits, with all types of interferences between them thereby avoided.

Furthermore, the interconnection between the two conducting sides of a double-sided printed circuit with a rigid substrate of between 0.1 and 0.3 mm will be embodied differently by means of a passing screw, thereby eliminating the operation of inserting pins in certain cases, thus providing greater space, since the insertion of pins requires greater space between the holes as soldering pads have to be provided, i.e. the space occupied by the soldered tin around the pin. A further improvement will be the reduction in on-line assembly work, since the pin-insertion operation is eliminated.

Another of the improvements suggested is that interconnection between the conducting sides of a mixed circuit may be carried out via the metallisation of its holes.

Another additional effect achieved with the increased thickness of the conducting parts from 400 microns to 800 microns will be that when a greater amperage is not required it will be possible to build smaller power circuits, which means that besides greater integration, the size of the service boxes (10) will also be reduced.

Finally, another improvement in this invention consists of the stitching of boards horizontally using staples (28), see figure no. 15, where a first printed circuit (15) will combine one area with another (15) using long pins (21), located on the bottom part, whereas the other area will combine with another circuit using long pins (21), with the two printed circuits (15 - 27) being joined by staples (28). This type of mechanical joining will make all kinds of box (10) architecture possible, because furthermore, the external configuration of the boxes must also be adapted to the configuration of the area of the car where they are to be installed.

Now that the Patent application has been properly described, as shown in the attached plans, it may be understood that any detailed modifications deemed necessary may be introduced, provided that any variations introduced do not alter the essence of the Patent which is summarised in the following Claims.

## Claims

1. "IMPROVEMENTS INTRODUCED INTO THE OBJECT OF THE INVENTION PATENT No. 9501610 by ELECTRONIC INTEGRATION IN SERVICE BOXES" (10) of the kind which are formed by a container element, inside which a number of signal and power or mixed signal-power printed circuits are arranged, and to which the corresponding electrical or electronic elements have been attached, the said signal, power or mixed circuits being joined directly or with the help of short pins (17) or long pins (21), in which the signal circuits have a Cu conducting part with a thickness of 35, 70 or 105 microns, whereas the thickness of the power circuit may be up to 400 microns, characterised in that the power circuits (23) which are part of a box (10) may be constructed with a Cu conducting layer thickness of up to 800 microns, and the signal circuits may have Cu conducting layer thicknesses of up to 200 microns.

2. "IMPROVEMENTS INTRODUCED INTO THE OBJECT OF THE INVENTION PATENT No. 9501610 by ELECTRONIC INTEGRATION IN SERVICE BOXES" characterised according to the 1^{st} claim in that the mixed signal-power circuits on the dielectric substrate any contain any combination of thicknesses according to the previous ranges, i.e. up to 200 microns in signal circuits and up to 800 microns in power circuits.

3. "IMPROVEMENTS INTRODUCED INTO THE OBJECT OF THE INVENTION PATENT No. 9501610 by ELECTRONIC INTEGRATION IN SERVICE BOXES" characterised according to the 1^{st} claim in that the assembly of an electronic circuit (20) may be conducted using male-female connections.

4. "IMPROVEMENTS INTRODUCED INTO THE OBJECT OF THE INVENTION PATENT No. 9501610 by ELECTRONIC INTEGRATION IN SERVICE BOXES" characterised according to the 1^{st} claim in that the mixed signal-power circuits may also be multilayer.

5. "IMPROVEMENTS INTRODUCED INTO THE OBJECT OF THE INVENTION PATENT No. 9501610 by ELECTRONIC INTEGRATION IN SERVICE BOXES" characterised according to the 1^{st} claim in that the interconnection between the two sides with rigid substrate between 0.1 and 0.3 mm may be carried out by means of a soldered passing screw.

6. "IMPROVEMENTS INTRODUCED INTO THE OBJECT OF THE INVENTION PATENT No. 9501610 by ELECTRONIC INTEGRATION IN SERVICE BOXES" characterised according to the 1^{st} claim in that the interconnection between the conducting sides of a mixed signal-power printed circuit can be carried out by means of the metallisation of the screw holes.

7. "IMPROVEMENTS INTRODUCED INTO THE OBJECT OF THE INVENTION PATENT No. 9501610 by ELECTRONIC INTEGRATION IN SERVICE BOXES" characterised according to the 1^{st} claim in that printed circuits (15) and (27) can be joined horizontally and mechanically by staples (28).
